(19) Europäisches Patentamt

European Patent Office

Office européen des brevets

(11) **EP 0 639 796 B1**

(12) **EUROPÄISCHE PATENTSCHRIFT**

(45) Veröffentlichungstag und Bekanntmachung des Hinweises auf die Patenterteilung:
**13.05.1998 Patentblatt 1998/20**

(51) Int Cl.$^6$: **G03F 3/10**

(21) Anmeldenummer: **94111462.1**

(22) Anmeldetag: **22.07.1994**

(54) **Verfahren zur Herstellung eines Farbbilds, Schichtmaterial zur Durchführung des Verfahrens und nach dem Verfahren hergestelltes Farbbild**

Process for making a colour image, layered material for carrying out the process, and colour image produced by the process

Procédé pour produire une image en couleurs, matériau en couches pour réaliser le procédé et image en couleurs obtenue par le procédé

(84) Benannte Vertragsstaaten:
**BE DE FR GB IT**

(30) Priorität: **30.07.1993 DE 4325684**

(43) Veröffentlichungstag der Anmeldung:
**22.02.1995 Patentblatt 1995/08**

(73) Patentinhaber: **Agfa-Gevaert AG**
**51373 Leverkusen (DE)**

(72) Erfinder:
• **Benzing, Dr. Martin**
**D-55234 Biebelnheim (DE)**
• **Mohr, Dr. Dieter**
**D-55437 Appenheim (DE)**

• **Mertes, Dr. Jürgen**
**D-55435 Gau-Algesheim (DE)**
• **Blum, Peter**
**D-61476 Kronberg (DE)**

(56) Entgegenhaltungen:
**EP-A- 0 186 194     EP-A- 0 305 599**
**EP-A- 0 420 675     EP-A- 0 525 624**
**US-A- 4 262 071**

• **RESEARCH DISCLOSURE Bd. 317, Nr. 3175, September 1990, EMSWORTH, GB; Seiten 742-746 XP141468 'Process for the Rescreening of Halftone Images'**

**Beschreibung**

Die Erfindung betrifft ein Verfahren zur Herstellung eines Farbbilds, insbesondere für die Farbprüfung von Kopiervorlagen für den Mehrfarbendruck. Sie betrifft ferner ein Schichtmaterial, das zur Durchführung des Verfahrens geeignet ist sowie ein Farbbild, insbesondere ein Mehrfarbenbild, das nach dem Verfahren erhältlich ist.

Im Mehrfarbendruck wird im allgemeinen eine Farbprüfung vorgenommen, um die Korrektur der für die Belichtung von Druckplatten verwendeten Farbauszüge zu ermöglichen. Das Farbprüfbild muß ein getreues Abbild des gewünschten Raster- oder Strichbildes sein und soll den Tonwert der Farben naturgetreu und möglichst identisch zum späteren Druckbild wiedergeben. Die visuelle Farbprüfung soll Fehler in der Vorlage anzeigen, die beste Farbwiedergabe, die beim Drucken in der Maschine zu erwarten ist, erkennen lassen, die genaue Gradation aller Farbtöne wiedergeben und aufzeigen, ob die Grautöne neutral sind. Sie soll ferner die eventuelle Notwendigkeit zur Abschwächung einer der Farben angeben und/oder Hinweise zur Änderung der Filmvorlage vor der Herstellung der Druckplatten liefern.

Bei dieser Farbprüfung ist es üblich, nacheinander Teilfarbenbilder entsprechend den Grundfarben des Mehrfarbendrucks auf einem Bildempfangsmaterial zu erzeugen bzw. auf dieses zu übertragen, so daß die passergenau übereinanderliegenden Teilfarbenbilder ein naturgetreues Mehrfarbenbild ergeben.

Das Teilfarbenbild kann u. a. durch Belichten und Auswaschen einer lichtempfindlichen fertigen Schicht, durch Belichten und Auseinanderziehen von Trägerund Deckfolie eines Schichtmaterials mit dazwischenliegender lichtempfindlicher-Schicht, wobei die belichteten Schichtbereiche an der einen und die unbelichteten an der anderen Folie haften ("peel-apart"-Verfahren) oder durch Betonern oder Einfärben eines entwickelten farblosen Bilds erzeugt werden. Als lichtempfindliche Bestandteile werden dabei zumeist Diazoverbindungen oder photopolymerisierbare Gemische eingesetzt.

Zur Herstellung des Mehrfarbenbilds aus den einzelnen Teilfarbenbildern hat es sich besonders bewährt, die lichtempfindlichen Schichten für die einzelnen Farben nacheinander auf ein Bildempfangsmaterial zu laminieren, dort zu belichten und zum Teilfarbenbild zu entwickeln. Dieser Verfahrensweise wird der Vorzug gegenüber der Möglichkeit gegeben, jedes Teilfarbenbild getrennt herzustellen und nacheinander auf das Bildempfangsmaterial zu übertragen. Im letzteren Fall ist ein Laminieren im Register erforderlich, das apparativ sehr viel schwieriger zu bewerkstelligen ist als eine Belichtung im Register.

In den US-A 4 260 673, 4 650 738, 4 656 114 und 4 659 642 und der EP-A 447 829 werden lichtempfindliche Materialien auf Basis von Diazoverbindungen zur Herstellung von Farbprüffolien beschrieben, die in der Weise verarbeitet werden, daß zuerst die unbelichtete lichtempfindliche Schicht auf das Bildempfangsmaterial laminiert, dann im Register belichtet und durch Auswaschen entwickelt wird.

In den US-A 4 895 787 und 5 049 476 werden Farbprüfverfahren beschrieben, bei denen ebenfalls lichtempfindliche Farbschichten auf ein Bildempfangsmaterial übertragen, dort belichtet und entwickelt werden. Diese Materialien basieren auf photopolymerisierbaren Gemischen und werden durch "peel-apart"-Technik entwickelt.

Alle diese Materialien, mit denen Mehrfarbenbilder durch registermäßigen Aufbau aus Teilfarbenbildern erzeugt werden, enthalten Trenn- und/oder Haftschichten, die in dem fertigen Mehrfarbenbild zwischen den einzelnen Teilfarbenbildern verbleiben. Diese farblosen Zwischenschichten verursachen aber eine optische Vergrößerung der einzelnen Bildelemente, d. h. der Rasterpunkte bei Rasterbildern, die im allgemeinen als optischer Punktzuwachs bezeichnet wird. Dieser optische Punktzuwachs ist durchaus erwünscht und notwendig, um den Punktzuwachs, der im Offsetdruck im Bereich von etwa 8 - 30 % gegenüber der Vorlage liegen kann, angenähert zu simulieren. Der Punktzuwachs im Farbprüfbild kann innerhalb gewisser Grenzen durch Erhöhen oder Vermindern des Schichtgewichts der Trenn- und Haftschichten gesteuert werden. So wird z. B. in der US-A 4 262 071 das Einbringen einer Abstandsschicht zur Erhöhung des Punktzuwachses beschrieben.

Die Einstellung von Punktzuwächsen im höheren Bereich läßt sich mit den bekannten Methoden relativ gut bewerkstelligen. Es ist wesentlich schwieriger, Zuwächse im Bereich von 8 bis 20 % einzustellen, d. h. den im unkorrigierten Farbbild eintretenden Zuwachs zu reduzieren. In der EP-A 305 599 wird die Reduzierung durch Einsatz eines Trägermaterials beschrieben, das eine Beschichtung mit $TiO_2$ aufweist. Eine spezielle Möglichkeit beschreibt die US-A 4 734 356. Dort werden positiv arbeitenden Farbprüffolien, die auf optische Aufheller enthaltenden photopolymerisierbaren Gemischen beruhen, durch Betonern sichtbar gemacht. In der US-A 4 889 787 werden lichtempfindliche Farbprüffolien beschrieben, die sehr dünne Haftschichten (1,0 bis 3,2 g/m$^2$) enthalten und dadurch sehr niedrige Punktzuwächse ergeben. Die Verarbeitung erfordert jedoch relativ hohe Laminiertemperaturen und niedrige Laminiergeschwindigkeiten.

In der EP-A 420 675 wird ein Farbprüfverfahren beschrieben, bei dem der Haftschicht der Farbprüffolie, die als erste auf das Empfangsmaterial laminiert wird, $TiO_2$ zugesetzt wird. Diese Haftschicht ist wesentlich dicker als die bei den weiteren Folien.

Dieses Verfahren erfordert, daß stets der Bildaufbau mit der gleichen Teilfarbe begonnen wird, d. h. der Farbfolie, die die dicke pigmentierte Haftschicht trägt. Auch wird dabei nur eine geringfügige Verminderung des Punktzuwachses erreicht.

Aufgabe der Erfindung war es, ein Verfahren zur Herstellung von Farbbildern, insbesondere Mehrfarbenbildern anzugeben, bei dem sich der Punktzuwachs im Prüfbild in gewünschtem Maße verringern läßt und bei dem durch Staubpartikel auf der Oberfläche der zu übertragenden Schicht verursachte Bildfehler bei der peel-apart-Verarbeitung vermieden werden können.

Die Erfindung geht aus von einem Verfahren zur Herstellung eines Farbbilds, bei dem man ein lichtempfindliches Material, das eine temporäre Trägerfolie, eine farbige lichtempfindliche Schicht und eine durch Erwärmen aktivierbare Haftschicht aufweist, bei erhöhter Temperatur und unter Druck auf ein Bildempfangsmaterial laminiert, die lichtempfindliche Schicht bildmäßig belichtet und zum Bild entwickelt, die temporäre Trägerfolie vor oder nach dem Belichten von dem Bildempfangsmaterial abzieht und ggf. diese Schritte mit mindestens einem weiteren lichtempfindlichen Material, dessen farbige Schicht eine andere Farbe hat, wiederholt.

Das erfindungsgemäße Verfahren ist dadurch gekennzeichnet, daß man ein Bildempfangsmaterial einsetzt, das auf einem Schichtträger eine ein weißes Pigment enthaltende Pigmentschicht trägt, wobei man die Pigmentschicht durch Laminieren unter Druck und Erwärmen von einer temporären Trägerfolie eines Schichtmaterials, das aus

- der temporären Trägerfolie,
- der Pigmentschicht, die mindestens 10 Gew.-% des weißen Pigments enthält, und
- einer auf die Pigmentschicht aufgebrachten Haftschicht, die bei Raumtemperatur nicht klebrig ist und einen Erweichungspunkt unterhalb 160°C hat,

besteht, auf das Bildempfangsmaterial überträgt.

Ein weiterer Gegenstand der Erfindung ist auch das genannte Schichtmaterial selbst gemäß den Ansprüchen 6 bis 9 sowie ein Farbbild, insbesondere ein Mehrfarbenbild, mit einem Schichtträger, mindestens einer durch Erwärmen aktivierbaren Haftschicht und mindestens einer durch bildmäßiges Belichten und Entwickeln einer farbigen lichtempfindlichen Schicht erhaltenen Bildschicht, das nach einem oder mehreren der Ansprüche 1 bis 5 herstellbar ist.

Bei dem erfindungsgemäßen Verfahren wird das Farbbild bevorzugt hergestellt, indem man die lichtempfindliche Schicht vor dem Abziehen der temporären Trägerfolie belichtet und das Bild durch Auseinanderziehen von temporärer Trägerfolie und Bildempfangsmaterial entwickelt.

Gemäß einer anderen Ausführungsform des Verfahrens wird zuerst die temporäre Trägerfolie von der lichtempfindlichen Schicht abgezogen und danach das Bild durch Auswaschen der belichteten lichtempfindlichen Schicht mit einer Entwicklerflüssigkeit entwickelt.

Bei dieser Ausführungsform wird die temporäre Trägerfolie bevorzugt vor dem Belichten abgezogen. In diesem Fall wird eine bessere Bildauflösung erzielt. Wenn es aber gewünscht wird, z. B. wenn die lichtempfindliche Schicht Neigung zur Klebrigkeit hat, kann die Belichtung auch - ebenso wie bei der zuerst beschriebenen Ausführungsform - durch die temporäre Trägerfolie hindurch erfolgen.

Wesentlich an dem erfindungsgemäßen Verfahren ist es, daß ein in besonderer Weise durch die farblose bzw. weiße Pigmentschicht modifiziertes Bildempfangsmaterial eingesetzt wird. Die Pigmentschicht enthält ein weißes, feinteiliges, unlösliches, insbesondere anorganisches Pigment. Als Pigmente sind vor allem die Oxide, Sulfide, Sulfate oder Carbonate von Metallen der 2. oder 4. Hauptgruppe oder der 2. oder 4. Nebengruppe des Periodensystems geeignet, soweit sie die vorstehend genannten Eigenschaften aufweisen. Beispiele sind $CaCO_3$, $BaSO_4$, $SrCO_3$, MgO, ZnS, ZnO, $SiO_2$ und $TiO_2$. Titandioxid wird besonders bevorzugt. Die mittlere Teilchengröße des Pigments beträgt im allgemeinen 0,1 bis 100, vorzugsweise 0,3 bis 30 μm. Der Mengenanteil des Pigments in der Pigmentschicht beträgt mindestens 10 Gew.-%. Im allgemeinen liegt er zwischen 10 und 95, vorzugsweise zwischen 35 und 80 Gew.-%.

Vorzugsweise enthält die Schicht ferner ein organisches Polymeres als Bindemittel. Dieses soll ein ausreichendes Filmbildungsvermögen aufweisen, mit dem Pigment verträglich und in einem geeigneten Beschichtungslösemittel löslich sein. Das Bindemittel ist vorzugsweise farblos und unempfindlich gegenüber Luftsauerstoff und ggf. anzuwendenden Verarbeitungslösungen; insbesondere sollte es bei längerer Lagerung im Licht und an der Luft nicht vergilben. Wenn das Material durch Auswaschen entwickelt werden soll, sollte das Bindemittel im Entwickler unlöslich sein; wenn die Entwicklung durch Auseinanderziehen erfolgt, sollte es bei der dabei herrschenden Temperatur praktisch nicht erweichen oder klebrig werden.

Als Bindemittel kommen langölige, mittelfette und kurzölige Alkydharze, mit Styrol oder Vinyltoluol modifizierte Alkydharze oder Silikonalkydharze, Zweikomponenten-Polyurethane, Polyester, Vinylpolymere, Vinylacrylatpolymere, Acrylharze, Nitrocellulosen, Celluloseester, z. B. Celluloseacetatpropionat oder Celluloseacetatbutyrat, Zweikomponenten-Epoxyharze, Epoxyharzester, Alkyd-Melaminharze, Phenolharze, z. B. Novolake oder ähnliche Harze, Polyvinylacetale sowie Copolymere der diese Polymeren bildenden Monomeren.

Die Pigmentschicht kann ferner in kleinen Mengen Farbstoffe oder Farbpigmente enthalten, um gewünschtenfalls die Einfärbung eines zu verwendenden Bedruckpapiers zu simulieren oder um eine ggf. auftretende Vergilbung des Farbprüfmaterials zu kompensieren. Das Gewicht der Pigmentschicht liegt im allgemeinen im Bereich von 0,3 bis 70, vorzugsweise von 2 bis 20 g/m².

Die Pigmentschicht kann auf jede technologisch geeignete Weise auf das Bildempfangsmaterial aufgebracht werden, z. B. durch Extrudieren, Beschichten aus einem geeigneten Lösemittel, durch Aufsprühen einer Dispersion oder durch Übertragen einer vorgefertigten Schicht unter Druck und Erwärmen. Wenn das Bildempfangsmaterial - wie häufig - ein Papier ist, hat sich das Übertragen durch Laminieren besonders bewährt. Dazu wird auf einer temporären Trägerfolie durch Beschichten und Trocknen eine Pigmentschicht der gewünschten Zusammensetzung und Dicke hergestellt und durch Laminieren und Abziehen der Trägerfolie auf das Bildempfangsmaterial übertragen. Hierbei kann es vorteilhaft sein, zur besseren Verankerung der Pigmentschicht auf diese eine Haftschicht aufzubringen, wie sie bei der Übertragung von Farbschichten üblich ist. Als temporäre Trägerfolien werden ebenfalls solche eingesetzt, wie sie beim Übertragen von Farbschichten oder -bildern üblich sind.

Die Oberfläche der Trägerfolie, auf der sich die Pigmentschicht befindet, darf nur ein begrenztes Haftvermögen haben, so daß die Verbindung lösbar ist. Geeignet sind z. B. Polyesterfolien mit Dicken im Bereich von 10 bis 250, bevorzugt 20 bis 100 µm. Die ggf. noch aufgebrachte Haftschicht hat im wesentlichen die gleiche Zusammensetzung und Beschaffenheit wie die bei bekannten Farbprüffolien verwendeten Haftschichten, d. h. sie ist bei Raumtemperatur nicht klebrig und hat einen Erweichungspunkt unterhalb 160, vorzugsweise unterhalb 100 °C. Sie hat im allgemeinen ein Trockenschichtgewicht von 2 bis 40, bevorzugt 8 bis 25 g/m². Sie wird auf die Pigmentschicht aus einem Lösemittel aufgebracht, das diese Schicht möglichst wenig anlöst.

Die bei dem erfindungsgemäßen Verfahren eingesetzten Pigmentschichten können im Rahmen ganz unterschiedlicher Farbprüfverfahren Anwendung finden. So ist es grundsätzlich möglich, die Farbprüfbilder durch Übertragen von Teilfarbenschichten, Belichten und Entwickeln, durch Übertragen von fertigen Teilfarbenbildern, durch Sichtbarmachen entwickelter Teilbilder durch Betonern oder Einfärben u. dgl. aufzubauen. Materialien und Verfahren dieser Art sind bekannt und z. B. in den eingangs genannten Druckschriften beschrieben. Das erfindungsgemäße Verfahren ist auch zur Herstellung einfarbiger Bilder in beliebigen Farbtönen geeignet, wenn es bei ihnen auf eine genaue Nachstellung der Flächendeckung einer Vorlage ankommt. Mit besonderem Vorteil wird es bei Farbprüfverfahren angewandt, bei denen das Bild durch Übertragen von Teilfarbenschichten auf ein Bildempfangsmaterial, Belichten und Entwickeln zum Teilfarbenbild und Wiederholen dieser Schritte aufgebaut wird. Die Entwicklung kann dabei durch Auswaschen oder - bevorzugt - durch Auseinanderziehen erfolgen.

Dieses Verfahren und dafür geeignete Materialien sind in der EP-A 352 055, den US-A 4 895 787 und 5 049 476 sowie der EP-A 525 624 beschrieben, auf deren Offenbarung hier verwiesen wird:

Bei der bevorzugten Ausführungsform des erfindungsgemäßen Verfahrens wird zunächst ein Schichtmaterial aus temporärer Trägerfolie, weißer Pigmentschicht und bevorzugt Haftschicht hergestellt und auf ein übliches Bildempfangsmaterial, z. B. ein Bedruckpapier, laminiert. Die Trägerfolie wird abgezogen, und auf der freiliegenden Pigmentschicht wird das Farbprüfbild in üblicher Weise aufgebaut.

Das geschieht bevorzugt durch Laminieren mit einer unbelichteten Farbprüffolie, die auf einem temporären Träger eine lichtempfindliche Farbschicht, bevorzugt eine photopolymerisierbare Schicht, und eine Haftschicht trägt. Die lichtempfindliche Schicht wird durch die Trägerfolie hindurch unter einer Vorlage belichtet und das Bild durch Auseinanderziehen von Trägerfolie und Bildempfangsblatt entwickelt, wobei die belichteten Schichtbereiche - wenn es sich um eine negativ arbeitende Schicht handelt - mit der Trägerfolie entfernt werden und die unbelichteten auf dem Bildempfangsmaterial als positives Teilfarbenbild zurückbleiben. Auf dieses erste Teilfarbenbild wird die Farbprüffolie der nächsten Teilfarbe laminiert, dort im Register zum ersten Bild belichtet und wie dieses entwickelt. So erhält man schließlich das vollständige Mehrfarbenbild.

Als Bildempfangsmaterial wird bei dem erfindungsgemäßen Verfahren ein flächiges Material eingesetzt, das unter den Bedingungen der Verarbeitung maßhaltig ist. Es kann aus Kunststoffolien, kunststoffbeschichtetem Spezialpapier oder normalem Bedruckpapier bestehen. Andere weiße oder auch nicht-weiße Empfangs materialien können ebenfalls eingesetzt werden, z. B. Metallfolien oder Glas. Durch den Einsatz der Weißpigmentschicht gemäß der Erfindung wird es auch möglich, wenig veredelte Papiere, die sonst nicht zu Farbprüfzwecken eingesetzt werden können, zu verwenden. Das Laminieren erfolgt zweckmäßig in einem hierfür vorgesehenen Gerät unter Druck und bei erhöhter Temperatur. Die Laminiertemperatur liegt gewöhnlich im Bereich von 60 bis 170, bevorzugt zwischen 70 und 130 °C.

Die Haftschicht der Farbprüffolie kann, wie oben erwähnt, aus einem Lösemittel oder Lösemittelgemisch, das die lichtempfindliche, bevorzugt photopolymerisierbare Farbschicht nicht anlöst, direkt auf diese aufgebracht und getrocknet werden. Sie kann auch zuerst auf eine temporäre Trägerfolie aufgebracht und von dort durch Laminieren und Abziehen der Trägerfolie auf die Farbschicht übertragen werden. Das direkte Aufbringen aus Lösemitteln auf diese Schicht wird bevorzugt. Geeignete Lösemittel, die die Farbschicht nicht anlösen, sind Wasser und gesättigte Kohlenwasserstoffe. Viele Polymere können aus wäßriger Dispersion aufgebracht werden; das Aufbringen aus Lösung wird aber bevorzugt. Hierfür eignen sich z. B. Salze von Polymerem mit Säuregruppen, z. B. Carboxylgruppen. Ein bevorzugtes Beispiel ist eine wäßrig-alkalische Lösung eines Vinylacetat/Crotonsäure-Copolymeren (⁽ᴿ⁾ Mowilith Ct 5). Andere geeignete Polymere sind Polyvinylacetat- oder Polyacrylatdispersionen. Das Polymere sollte eine Erweichungstemperatur im Bereich von 40 bis 200, vorzugsweise von 60 bis 120 °C, und bevorzugt einen Tg-Wert im Bereich von 20 bis 60 °C haben. Die Haftschicht kann außer dem thermoplastischen Polymeren noch Weichmacher, Restlöser, Oberflächenausgleichsmittel, Gleitmittel, Antistatika, optische Aufheller und/oder UV-Absorber enthalten. Ihr Schichtgewicht im trockenen Zustand beträgt normalerweise 2 bis 40, vorzugsweise 8 bis 25 g/m$^2$.

Als lichtempfindliche Schicht wird bevorzugt eine photopolymerisierbare Schicht eingesetzt. Sie enthält als wesentliche Bestandteile ein polymeres Bindemittel, eine radikalisch polymerisierbare Verbindung, einen Photoinitiator und einen Farbstoff oder ein Farbpigment, im allgemeinen in einer Grundfarbe des Mehrfarbendrucks. Beispiele für photopolymerisierbare Schichten dieser allgemeinen Zusammensetzung sind in der US-A 4 895 787 beschrieben.

Als Photoinitiatoren sind im wesentlichen alle für diesen Zweck bekannten Verbindungen oder Verbindungskombinationen geeignet. Beispiele sind Benzoinether, Benzilketale, Mehrkernchinone, Benzophenonderivate, Triarylimidazolyldimere, lichtempfindliche Trihalogenmethylverbindungen, z. B. Trichlormethyl-s-triazine. Bevorzugt werden 2,3-Bis-aryl-chinoxaline, wie sie in der US-A 3 765 898 beschrieben sind, und 2-Aryl-4,6-bis-trichlormethyl-s-triazine. Die Menge an Photoinitiator bzw. an Photoinitiatorkombination liegt im allgemeinen zwischen 1 und 25, vorzugsweise zwischen 5 und 15 Gew.-%, bezogen auf das Gewicht der trockenen Schicht.

Das polymere Bindemittel soll der Schicht Homogenität und Festigkeit verleihen. Geeignete Bindemittel sind Styrol/Maleinsäureanhydrid- und Styrol/Maleinsäurehalbester-Copolymere, Acrylesterpolymere und -copolymere, Polyamide, Polyvinylpyrrolidone, Cellulosederivate, wie Celluloseester und -ether, Phenolharze, Polyvinylester, Polyvinylacetale, z. B. Polyvinylbutyral, -propional oder -formal. Der Mengenanteil des Bindemittels beträgt im allgemeinen 15 bis 70, vorzugsweise 20 bis 50 Gew.-%, bezogen auf das Gewicht der festen Schicht.

Die polymerisierbare Verbindung enthält mindestens eine, bevorzugt mindestens zwei endständige radikalisch polymerisierbare Doppelbindungen und ist bei Temperaturen unterhalb 100 °C und bei Normaldruck nicht gasförmig. Bevorzugt werden Ester und Amide der Acryl- und Methacrylsäure. Besonders die Ester mit mehrwertigen Alkoholen werden mit Vorteil eingesetzt. Beispiele sind Di-, Tri-, Tetra- und Polyethylenglykoldi(meth)acrylat, die Di(meth)acrylate von Oligo- und Polypropylenglykolen, 1,4-Butandioldi(meth)acrylat, Trimethylolpropan- und Trimethylolethandi- und -tri(meth)acrylat, Pentaerythrittri- und -tetraacrylat oder -methacrylat, Dipentaerythrittetra-, -penta- und -hexa(meth)acrylat. Der Mengenanteil an polymerisierbarer Verbindung beträgt im allgemeinen 15 bis 70, vorzugsweise 20 bis 60 Gew.-%.

Die Farbstoffe bzw. Farbpigmente werden bevorzugt so ausgewählt, daß sie den Grundfarben des Mehrfarbendrucks, Cyan (Blaugrün); Magenta (Purpur); Gelb und Schwarz, entsprechen. Pigmente werden im allgemeinen bevorzugt. Beispiele sind Permanentgelb G (C.I. 21 095), Permanentgelb GR (C.I. 21 100), Permanentgelb DHG (C.I. 21 090), Permanentrubin L6B (C.I. 15 850 : 1), Permanent Pink F3B (V.I. 12 433), [R] Hostaperm Pink E (C.I. 73 915), [R] Hostaperm Rotviolett ER (C.I. 46 500), Permanentkarmin FBB (C.I. 12 485), [R] Hostapermblau B2G (C.I. 74 160), [R] Hostapermblau A2R (C.I. 74 160) und [R] Printex 25 (Ruß). Die Pigmente können ggf. zur Erzielung des gewünschten Farbtons abgemischt werden. Auch können beliebige andere Farbtöne, z. B. Gold, Silber, Bronze etc., hergestellt werden. Die anorganischen oder organischen Pigmente werden im allgemeinen zusammen mit einem Teil des Bindemittels in einem geeigneten Lösemittel dispergiert oder angeteigt. Die mittlere Partikelgröße liegt i. a. unterhalb 1 µm.

Der Mengenanteil des Farbstoffs oder Pigments beträgt im allgemeinen 8 bis 40, vorzugsweise 12 bis 30 Gew.-%.

Die photopolymerisierbare Schicht kann ggf. weitere Bestandteile, wie Wasserstoffdonatoren, Sensibilisatoren, Polymerisationsinhibitoren, Weichmacher, Restlöser, Tenside, Oberflächenausgleichsmittel, Gleitmittel, Antistatika, inerte Füllstoffe, optische Aufheller und/oder UV-Absorber, enthalten. Sie hat im allgemeinen ein Schichtgewicht von 0,2 bis 5, bevorzugt 0,3 bis 3 g/m$^2$.

Als Trägerfolien werden transparente, flexible, dimensionsstabile Folien aus Kunststoffen, z. B. Polyestern, Polycarbonaten usw., eingesetzt. Besonders bevorzugt werden Polyesterfolien, insbesondere biaxial verstreckte und wärmefixierte Folien, z. B. aus Polyethylenterephthalat. Diese sollten bei den erforderlichen Laminiertemperaturen, d. h. von etwa 60 bis 150 °C maßhaltig bleiben. Ihre Dicke beträgt im allgemeinen 10 bis 200, vorzugsweise 25 bis 80 µm. Die Trägerfolie wird vorteilhaft ein- oder beidseitig haftvermittelnd vorbehandelt und kann eine glatte oder eine rauhe bzw. matte, vorzugsweise eine glatte Oberfläche haben.

Durch den Einsatz des erfindungsgemäßen Materials und Verfahrens wird erreicht, daß das Farbprüfbild einen geringeren Punktzuwachs oder eine geringere Flächendeckung im Rasterbild aufweist als ein entsprechendes Bild, das mit einem Material ohne die erfindungsgemäß eingesetzte Weißpigmentschicht hergestellt worden ist. Ferner wird erreicht, daß durch Ausreißen von Bildstellen der Farbschicht entstandene Bildfehler, die durch Staubeinschlüsse oder Blasenbildung während des Laminierens bedingt sein können, weitgehend unterdrückt werden. Gegenüber dem Verfahren der EP-A 420 675, bei dem die Haftschicht der ersten Farbprüffolie mit TiO$_2$ versetzt wird, ergibt das erfindungsgemäße Verfahren einen deutlich geringeren Punktzuwachs.

Die folgenden Beispiele erläutern bevorzugte Ausführungsformen der Erfindung. Mengen werden zumeist in Gewichtsteilen (Gt) angegeben; Prozentzahlen und Mengenverhältnisse sind in Gewichtseinheiten zu verstehen, wenn nichts anderes angegeben ist.

Beispiel 1

Auf eine 50 µm dicke Folie aus Polyethylenterephthalat als temporärem Schichtträger wurde eine Pigmentschicht (Weißschicht) aufgebracht, die ein Trockengewicht von ca. 8 g/m² hatte. Die folgende Beschichtungslösung wurde aufgerakelt und bei 100 °C im Trockenschrank 2 Minuten getrocknet:

| | |
|---|---|
| 50 Gt | eines mit einem Acrylatpolymeren oberflächlich modifizierten $TiO_2$-Pigments mit 0,7 µm mittlerer Teilchengröße, |
| 50 Gt | 1 -Methoxyprop-2-yl-acetat. |

Im folgenden Schritt wurde auf die Pigmentschicht eine Haftschicht mit einem Trockengewicht von ca. 6 g/m² durch Beschichten mit der folgenden Lösung aufgebracht:

| | |
|---|---|
| 15 Gt | eines Copolymeren aus 95 % Vinylacetat und 5 % Crotonsäure, |
| 17 Gt | Ethanol, |
| 67 Gt | Wasser (vollentsalzt), |
| 1 Gt | Ammoniaklösung (25 %ig in Wasser). |

Es wurden vier lichtempfindliche Materialien zur Herstellung von Farbprüffolien hergestellt. Dazu wurden vier Beschichtungslösungen in den Grundfarben Cyan, Gelb, Magenta und Schwarz der in der folgenden Tabelle angegebenen Zusammensetzung (in Gewichtsteilen) jeweils auf eine 50 µm dicke Folie aus biaxial gerecktem und thermofixiertem Polyethylenterephthalat, deren Oberfläche zur Haftvermittlung vorbehandelt worden war, aufgebracht und getrocknet:

Tabelle 1

| Bestandteil | Cyan | Gelb | Magenta | Schwarz |
|---|---|---|---|---|
| Tetrahydrofuran | 200 | 200 | 200 | 200 |
| 4-Hydroxy-4-methyl-2-pentanon | 150 | 150 | 150 | 150 |
| 1-Methoxy-2-propanol | 444 | 465 | 489 | 490 |
| γ-Butyrolacton | 44 | 65 | 89 | 90 |
| Polyvinylformal ($\overline{M}$ = 80000; 24 % Vinylalkohol-, 26 % Vinylacetat- und 50 % Vinylformaleinheiten) | 6 | 13 | 18 | 9 |
| Dipentaerythritpentaacrylat | 8 | 12 | 8 | 12 |
| 2,3-Bis(4-methoxy-phenyl)-chinoxalin | 4 | 4 | 4 | 4 |
| (R)Hostapermblau B2G (C.I.74160) | 7 | - | - | - |
| Permanentgelb GR (C.I. 21100) | - | 7 | - | - |
| Permanentcarmin FBB (C.I.12485) | - | - | 12 | - |
| Ruß ((R) Printex 25) | - | - | - | 11 |

Die Pigmente wurden zusammen mit einem Teil des Bindemittels und der Lösemittel dispergiert. Sie wurden dann zu einem mittleren Durchmesser von weniger als 0,2 µm vermahlen und zu dem Rest der Lösung gegeben. Auf ähnliche Polyesterfolien, die aber nicht zur Haftvermittlung vorbehandelt waren, wurde eine Lösung von

78 Gt n-Butylacetat,

1 Gt polymerer Weichmacher ((R) Resoflex R 296),

21 Gt Polyvinylacetat (MG 110.000; Tg 28 °C) aufgebracht und getrocknet. Die trockene Schicht hatte ein Gewicht von 12 g/m². Auf jede der vier lichtempfindlichen Folien wurde eine Folie mit der Haftschicht laminiert und danach die Trägerfolie der Haftschicht abgezogen.

Das getrocknete, mit der Weißschicht versehene Schichtmaterial wurde wie folgt verarbeitet:

1. Auflaminieren des Schichtmaterials auf ein naßfestes, beidseitig mit Polyethylen beschichtetes Spezialpapier unter Anwendung eines Drucks von etwa 300 kPa.

2. Abziehen des temporären Schichtträgers, wodurch die pigmentierte Schicht freigelegt wurde.

3. Auflaminieren der ersten Farbfolie (Cyan) auf die freigelegte Pigmentschicht.

4. Belichten mit aktinischem Licht unter einem entsprechenden Farbauszugsfilm.

5. Abziehen der Polyesterträgerfolie, wobei die Nichtbildbereiche mit der Folie entfernt wurden.

6. Wiederholen der Schritte 3 bis 5 mit den restlichen Farben, d. h. Magenta, Gelb und Schwarz.

Die Flächendeckung wurde mit einem handelsüblichen Auflichtdensitometer (D 186 von Gretag) gemessen.

Tabelle 2 zeigt den Punktzuwachs in % im 40 %-Feld des Ugra-Testkeils (60er-Raster), bei Farbprüfbildern mit und ohne Weißschicht (W), welche auf verschiedenen Bildempfangsmaterialien (Ozasol [(R)] TF 01 und TF 03), auf unterschiedliche Tonwertwiedergabe belichtet, hergestellt wurden. TF 01 ist ein rein weißes Spezialpapier, TF 03 ein zur Simulation von üblichem Zeitungspapier leicht grau eingefärbtes Spezialpapier.

Tabelle 2

| Trägermaterial | Auflösungsvermögen | Punktzuwachs über 40 % hinaus | | | (% absolut) Schwarz |
|---|---|---|---|---|---|
| | | Cyan | Magenta | Gelb | |
| TF 01 | 2 - 97 % | 21 | 22 | 19 | 24 |
| TF 01 + W | 2 - 97 % | 17 | 19 | 16 | 21 |
| TF 03 | 2 - 97 % | 22 | 18 | 17 | 23 |
| TF 03 + W | 2 - 97 % | 18 | 16 | 14 | 19 |
| TF 01 | 3 - 98 % | 21 | 19 | 19 | 21 |
| TF 01 + W | 3 - 98 % | 17 | 16 | 16 | 18 |
| TF 03 | 3 - 98 % | 18 | 17 | 16 | 20 |
| TF 03 + W | 3 - 98 % | 14 | 15 | 15 | 17 |

Beispiel 2

Es wurde wie in Beispiel 1 gearbeitet, jedoch wurde eine Pigmentschichtlösung der folgenden Zusammensetzung eingesetzt:

35 Gt des in Beispiel 1 angegebenen $TiO_2$-Pigments,

15 Gt Polybrenzkatechinmonomethacrylat,

30 Gt Tetrahydrofuran,

20 Gt 1 Methoxyprop-2-yl-acetat.

Die mit diesem Material erzielten Resultate entsprachen im wesentlichen den in Tabelle 2 aufgelisteten Ergebnissen. Das zugesetzte Polymere hatte keinen Einfluß auf den Punktzuwachs.

Beispiel 3

Es wurde wie in Beispiel 1 gearbeitet, jedoch wurde eine Pigmentschichtlösung der folgenden Zusammensetzung eingesetzt:

40 Gt des in Beispiel 1 angegebenen $TiO_2$-Pigments,

10 Gt eines Kresol-Formaldehyd-Novolaks mit einem Schmelzbereich von 120-135 °C,

50 Gt Butanon.

Die mit diesem Material erzielten Resultate entsprachen im wesentlichen denen von Tabelle 2. Der Novolak hatte keinen Einfluß auf den Punktzuwachs.

Beispiel 4

Es wurde wie in Beispiel 1 gearbeitet, jedoch wurde eine Pigmentschichtlösung der folgenden Zusammensetzung eingesetzt:

24 Gt des in Beispiel 1 angegebenen $TiO_2$-Pigments,

6 Gt Polyvinylformal wie in Beispiel 1,

55 Gt Tetrahydrofuran,

15 Gt 1-Methoxy-2-propanol.

Die mit diesem Material erzielten Resultate entsprachen im wesentlichen denen von Tabelle 2. Das zugesetzte Polymere hatte keinen Einfluß auf den Punktzuwachs.

Beispiel 5

Es wurde wie in Beispiel 1 gearbeitet, jedoch wurde eine Pigmentschichtlösung der folgenden Zusammensetzung eingesetzt:

24 Gt des in Beispiel 1 angegebenen $TiO_2$-Pigments,

6 Gt Polyvinylpropional mit 13,6 % Vinylacetat-, 9,8 % Vinylalkohol- und 76,6 % Vinylpropionalgruppen,

70 Gt 1-Methoxy-2-propanol.

Die mit diesem Material erzielten Resultate entsprachen im wesentlichen denen der Tabelle 2. Das zugesetzte Polymere hatte keinen Einfluß auf den Punktzuwachs.

Beispiel 6

Es wurde wie in Beispiel 1 gearbeitet, jedoch wurde eine Pigmentschichtlösung der folgenden Zusammensetzung eingesetzt:

40 Gt des in Beispiel 1 angegebenen $TiO_2$-Pigments,

10 Gt eines Polymeren mit der Säurezahl 40, hergestellt durch Umsetzen von 50 Gt eines Polyvinylbutyrals mit einem Molekulargewicht von 70.000 bis 80.000, das 71 % Vinylbutyral-, 2 % Vinylacetat- und 27 % Vinylalkoholeinheiten enthielt, mit 4 Gt Maleinsäureanhydrid,

50 Gt Butanon.

Die mit diesem Material erzielten Resultate entsprachen im wesentlichen denen der Tabelle 2. Das zugesetzte Polymere hatte keinen Einfluß auf den Punktzuwachs.

Beispiel 7

Es wurde wie in Beispiel 1 gearbeitet, jedoch wurde eine Pigmentschichtlösung der folgenden Zusammensetzung eingesetzt:

49,95 Gt des in Beispiel 1 angegebenen $TiO_2$-Pigments,

0,05 Gt eines blauviolett gefärbten Toners (Tint Ayd [R] UL 20-12),

50,00 Gt 1-Methoxyprop-2-yl-acetat.

Die mit diesem Material erzielten Resultate entsprachen im wesentlichen denen der Tabelle 2. Der zugesetzte Toner hatte keinen Einfluß auf den Punktzuwachs.

Beispiele 8-13

Es wurde wie in Beispiel 1 gearbeitet, jedoch wurden Pigmentschichten mit einem Trockengewicht von jeweils 3, 6, 10, 16, 20 und 26 g/m² aufgebracht. Die erhaltene Flächendeckung wurde mit dem in Beispiel 1 angegebenen Auflichtdensitometer gemessen.

Tabelle 3 zeigt den Punktzuwachs (in %) der Farbe Cyan im 40 %-Feld des Ugra-Testkeils (60er Raster), zuerst als Einzelfarbe im Teilfarbenbild und dann im Vierfarbenprüfbild gemessen, d. h. an einer Stelle, an der der Cyankeil noch von den Haftschichten der drei übrigen Teilfarbenbilder bedeckt war.

Tabelle 3

| Schichtgewicht | Cyan als Einzelfarbe | Cyan im Vierfarbenbild |
|---|---|---|
| 0 g/m² | 15 | 21 |
| 3 g/m² | 12 | 18 |
| 6 g/m² | 10 | 17 |
| 10 g/m² | 9 | 17 |
| 16 g/m² | 7 | 15 |
| 20 g/m² | 7 | 16 |
| 26 g/m² | 6 | 15 |

Beispiele 14-26

Es wurde wie in den Beispielen 1-13 gearbeitet, jedoch wurde in jedem Fall eine Haftschicht mit einem Trockengewicht von ca. 18 g/m² aufgebracht. Die mit diesen Materialien erzielten Resultate entsprachen im wesentlichen denen der Beispiele 1-13. Die Dicke der Haftschicht beeinflußte den Punktzuwachs nicht.

Beispiele 27-52

Es wurde wie in den Beispielen 1-26 gearbeitet, jedoch wurde jeweils eine Haftschichtlösung der folgenden Zusammensetzung eingesetzt:

10 Gt Copolymeres aus Styrol und Butadien (ca. 80 % Styrol und 20 % Butadien),
90 Gt Toluol.

Die mit diesen Materialien erzielten Resultate entsprachen im wesentlichen denen der Beispiele 1 bis 26. Die Art der Haftschicht war ohne Auswirkung auf den Punktzuwachs.

Beispiele 53-78

Es wurde wie in den Beispielen 1-26 gearbeitet, jedoch wurde jeweils eine Haftschichtlösung der folgenden Zusammensetzung eingesetzt:

10 Gt Polyvinylacetat (MG 110.000; Tg 28 °C),
90 Gt Butylacetat.

Die mit diesen Materialien erzielten Resultate entsprachen im wesentlichen denen der Beispiele 1-26. Die Art der Haftschicht war ohne Auswirkung auf den Punktzuwachs.

Beispiel 79

Auf eine 50 μm dicke Folie aus Polyethylenterephthalat als temporärer Schichtträger wurde eine Trennschicht aufgebracht, die ein Trockengewicht von 0,7 - 1,0 g/m$^2$ hatte. Die Lösung wurde aufgerakelt und bei 100 °C im Trockenschrank 3 Minuten getrocknet.

Beschichtungslösung A

120 Gt Polyvinylalkohol (Pw=530, Hydrolysegrad 88 mol.-%),
120 Gt Polyvinylalkohol (Pw=1000, Hydrolysegrad 88 mol-%),
6,7 Gt Nonylphenolpolyglykolether,
6800 Gt deionisiertes Wasser.

Im folgenden Schritt wurde auf die Trennschicht die farbige lichtempfindliche Schicht mit Hilfe einer Schleuder aufgebracht. Die Beschichtungslösung für die lichtempfindliche Schicht wurde in zwei Stufen hergestellt:

Beschichtungslösung B (Pigmentdispersion)

5,5 Gt Polyvinylpropional wie im Beispiel 5,
6,5 Gt Hostapermblau B2G (C.I. 74160),
44 Gt Propylenglykolmonomethylether
44 Gt γ-Butyrolacton.

Beschichtungslösung C

12,5 Gt Polybrenzkatechinmonomethacrylat (RSV-Wert: 0,210 in Dimethylformamid),
6,5 Gt Beschichtungslösung B,
1,1 Gt Veresterungsprodukt aus
1 mol 2,3,4-Trihydroxy-benzophenon und
3 mol 1,2-Naphthochinon-2-diazid-4-sulfonsäure,
36,4 Gt Propylenglykolmonomethylether,
43,5 Gt Tetrahydrofuran.

Die Lösung wurde auf die mit der Trennschicht versehene Folie so aufgeschleudert, daß sich nach dem Trocknen (2 Minuten, 110 °C) ein Schichtgewicht von 1,5 g/m$^2$ einstellte. Die Farbdichte, gemessen mit einem Gretag Densitometer durch ein Blau-Filter, betrug 1,2.

Auf die lichtempfindliche Schicht wurde abschließend noch eine Haftschicht aus 97 Gew.-% eines Styrol-Butadien-Copolymerisats (Tg = 50 °C) und 3 Gew.-% eines Polyesters (Desmophen [R] 1700, BAYER AG) mit einem Trockengewicht von 3 g/m$^2$ aufgebracht.

Die so erhaltene Farbprüffolie wurde mit der Haftschicht auf ein Empfangsblatt laminiert, das wie in Beispiel 1 beschrieben, mit einer Weißschicht versehen war. Nach dem Laminieren wurde die Trägerfolie abgezogen. Die Haftschicht und die gefärbte lichtempfindliche Schicht blieben dabei auf dem Empfangsblatt zurück.

Die lichtempfindliche Schicht wurde dann in bekannter Weise mit einer UV-Lichtquelle durch eine Photomaske im Vakuumkopierrahmen bildmäßig belichtet und mit einer wäßrig-alkalischen Lösung entwickelt, die aus

92 Gt Wasser,
3 Gt Natriumoctylsulfat,
3 Gt Kaliummetasilikat,
1 Gt Phenoxyethanol und
1 Gt Trinatriumphosphat

bestand, wobei die vom Licht getroffenen Anteile der Schicht sowie die gesamte Trennschicht entfernt wurden. Die beschriebenen Schritte wurden mit den restlichen Farben wiederholt.

Auch mit dem Material und Verfahren dieses Beispiels lag der Punktzuwachs in der gleichen Größenordnung wie bei den Materialien des Beispiels 1.

**Patentansprüche**

1. Verfahren zur Herstellung eines Farbbilds, bei dem man ein lichtempfindliches Material, das eine temporäre Trägerfolie, eine farbige lichtempfindliche Schicht und eine durch Erwärmen aktivierbare Haftschicht aufweist, bei erhöhter Temperatur und unter Druck auf ein Bildempfangsmaterial laminiert, die lichtempfindliche Schicht bildmäßig belichtet und zum Bild entwickelt, die temporäre Trägerfolie vor oder nach dem Belichten von dem Bildempfangsmaterial abzieht und ggf. diese Schritte mit mindestens einem weiteren lichtempfindlichen Material, dessen farbige Schicht eine andere Farbe hat, wiederholt, dadurch gekennzeichnet, daß man ein Bildempfangsmaterial einsetzt, das auf einem Schichtträger eine ein weißes Pigment enthaltende Pigmentschicht trägt, wobei man die Pigmentschicht durch Laminieren unter Druck und Erwärmen von einer temporären Trägerfolie eines Schichtmaterials, das aus

   - der temporären Trägerfolie,
   - der Pigmentschicht, die mindestens 10 Gew.-% des weißen Pigments enthält, und
   - einer auf die Pigmentschicht aufgebrachten Haftschicht, die bei Raumtemperatur nicht klebrig ist und einen Erweichungspunkt unterhalb 160 °C hat,

   besteht, auf das Bildempfangsmaterial überträgt.

2. Verfahren nach Anspruch 1, dadurch gekennzeichnet, daß die Pigmentschicht des Bildempfangsmaterials ein polymeres Bindemittel enthält.

3. Verfahren nach Anspruch 1, dadurch gekennzeichnet, daß man die lichtempfindliche Schicht vor dem Abziehen der temporären Trägerfolie belichtet und das Bild durch Auseinanderziehen von temporärer Trägerfolie und Bildempfangsmaterial entwickelt.

4. Verfahren nach Anspruch 1, dadurch gekennzeichnet, daß man die temporäre Trägerfolie von der lichtempfindlichen Schicht abzieht und das Bild durch Auswaschen der belichteten lichtempfindlichen Schicht mit einer Entwicklerflüssigkeit entwickelt.

5. Verfahren nach Anspruch 4, dadurch gekennzeichnet, daß man die temporäre Trägerfolie vor dem Belichten abzieht.

6. Schichtmaterial zum Übertragen einer weißen Pigmentschicht auf ein Bildempfangsmaterial zur Herstellung von farbigen Bildern, das aus

   - einer temporären Trägerfolie,
   - einer Pigmentschicht, die mindestens 10 Gew.-% eines weißes Pigments und gegebenenfalls ein polymeres Bindemittel enthält, und
   - einer Haftschicht, die bei Raumtemperatur nicht klebrig ist und einen Erweichungspunkt unterhalb 160 °C hat, besteht.

7. Schichtmaterial nach Anspruch 6, dadurch gekennzeichnet, daß das weiße Pigment ein anorganisches Pigment ist.

**8.** Schichtmaterial nach Anspruch 7, dadurch gekennzeichnet, daß das anorganische Pigment ein wasserunlösliches Oxid, Sulfid, Sulfat oder Carbonat eines Metalls der 2. oder 4. Hauptgruppe oder der 2. und 4. Nebengruppe des Periodensystems ist.

**9.** Schichtmaterial nach Anspruch 6, dadurch gekennzeichnet, daß das polymere Bindemittel ein Alkydharz, ein Phenolharz, ein Vinylpolymeres oder ein Polyacrylat oder -methacrylat ist.

**10.** Farbbild, herstellbar nach einem oder mehreren der Ansprüche 1 bis 5.

## Claims

**1.** Process for the production of a colour image in which a photosensitive material, which has a temporary support film, a coloured photosensitive layer and an adhesive layer activatable by heating, is laminated at elevated temperature and under pressure onto an image-receiving material, the photosensitive layer is exposed with the image and developed to yield the image, the temporary support film is peeled off the image-receiving material before or after exposure and these stages are optionally repeated with at least one further photosensitive material having a coloured layer of a different colour, characterised in that an image-receiving material is used which bears on a layer support a pigment layer containing a white pigment, wherein the pigment layer is transferred by lamination under pressure and with heating from a temporary support film of a layer material which consists of

- the temporary support film,
- the pigment layer, which contains at least 10 wt.% of the white pigment, and
- an adhesion layer applied onto the pigment layer, which adhesion layer is not tacky at room temperature and has a softening point of below 160°C.

**2.** Process according to claim 1, characterised in that the pigment layer of the image-receiving material contains a polymeric binder.

**3.** Process according to claim 1, characterised in that the photosensitive layer is exposed before the temporary support film is peeled off and the image is developed by peeling apart the temporary support film and image-receiving material.

**4.** Process according to claim 1, characterised in that the temporary support film is peeled off the photosensitive layer and the image is developed by washing the exposed photosensitive layer with a developer liquid.

**5.** Process according to claim 4, characterised in that the temporary support film is peeled off before exposure.

**6.** Layer material for transferring a white pigment onto an image-receiving material for the production of coloured images, which material consists of

- a temporary support film,
- a pigment layer, which contains at least 10 wt.% of a white pigment and optionally a polymeric binder, and
- an adhesion layer which is not tacky at room temperature and has a softening point of below 160°C.

**7.** Layer material according to claim 6, characterised in that the white pigment is an inorganic pigment.

**8.** Layer material according to claim 7, characterised in that the inorganic pigment is a water-insoluble oxide, sulphide, sulphate or carbonate of a metal of main group 2 or 4 or of sub-groups 2 and 4 of the periodic table.

**9.** Layer material according to claim 6, characterised in that the polymeric binder is an alkyd resin, a phenolic resin, a vinyl polymer or a polyacrylate or polymethacrylate.

**10.** Colour image producible in accordance with one or more of claims 1 to 5.

**Revendications**

1.  Procédé pour produire une image couleur dans lequel on lamine sur une matière réceptrice d'image une matière photosensible comprenant une feuille de support temporaire, une couche photosensible colorée et une couche d'adhérence activable à la chaleur, à température élevée et sous pression, on expose la couche photosensible à la lumière avec formation d'une image qu'on développe, on retire la feuille de support temporaire de la matière réceptrice d'image avant ou après l'exposition à la lumière et le cas échéant, on répète ces opérations avec au moins une autre matière photosensible dont la couche colorée a une autre couleur, ce procédé se caractérisant en ce que l'on utilise une matière réceptrice d'image qui porte, sur un support de couches, une couche pigmentée contenant un pigment blanc, la couche pigmentée étant transférée sur la matière réceptrice d'image par laminage sous pression et à chaud d'une feuille de support temporaire d'une matière multicouche consistant en :

    -   la feuille de support temporaire,
    -   la couche pigmentée contenant au moins 10 % en poids du pigment blanc, et
    -   une couche d'adhérence appliquée sur la couche pigmentée, qui n'est pas collante à température ambiante et a un point de ramollissement inférieur à 160°C.

2.  Procédé selon la revendication 1, caractérisé en ce que la couche pigmentée de la matière réceptrice d'image contient un liant polymère.

3.  Procédé selon la revendication 1, caractérisé en ce que l'on expose la couche photosensible à la lumière avant de retirer la feuille de support temporaire et on développe l'image par séparation de la feuille de support temporaire et de la matière réceptrice d'image.

4.  Procédé selon la revendication 1, caractérisé en ce que l'on sépare la feuille de support temporaire de la couche photosensible et on développe l'image par lavage de la couche photosensible exposée à l'aide d'un liquide révélateur.

5.  Procédé selon la revendication 4, caractérisé en ce que l'on retire la feuille de support temporaire avant l'exposition à la lumière.

6.  Matière multicouche pour le transfert d'une couche pigmentée blanche sur une matière réceptrice d'image en vue de la production d'images couleurs, cette matière multicouche consistant en :

    -   une feuille de support temporaire,
    -   une couche pigmentée contenant au moins 10 % en poids d'un pigment blanc et le cas échéant un liant polymère, et
    -   une couche d'adhérence non collante à température ambiante et qui a un point de ramollissement inférieur à 160°C.

7.  Matière multicouche selon la revendication 6, caractérisée en ce que le pigment blanc est un pigment minéral.

8.  Matière multicouche selon la revendication 7, caractérisée en ce que le pigment minéral est un oxyde, sulfure, sulfate ou carbonate d'un métal du 2$^e$ ou du 4$^e$ groupe principal ou du 2$^e$ et du 4$^e$ sous-groupes de la classification Périodique, insoluble dans l'eau.

9.  Matière multicouche selon la revendication 6, caractérisée en ce que le liant polymère est une résine alkyde, une résine phénolique, un polymère vinylique ou un polyacrylate ou polyméthacrylate.

10. Image couleur produite selon une ou plusieurs des revendications 1 à 5.